# EUROPEAN PATENT APPLICATION

(11) **EP 4 852 679 A1**
(43) Date of publication of application: **09.12.2026**
(21) Application number: 26212885.3
(22) Date of filing: 19.10.2026
(51) Int. Cl.: H10K 59/35

(54) **DISPLAY PANEL**

(30) Priority: 24.08.2026 CN 202611289881
(71) Applicant: Wuhan China Star Optoelectronics Semiconductor Display Technology Co., Ltd., Wuhan, Hubei 430079 (CN)
(72) Inventor: LI, Shuhui, Wuhan, Hubei, 430079 (CN); LIANG, Lu, Wuhan, Hubei, 430079 (CN)
(74) Representative: Berggren Oy

(57) **Abstract**

The present application provides a display panel. The display panel includes a plurality of pixel units (1), and each pixel unit includes a red sub-pixel (11), a green sub-pixel (12), a blue sub-pixel (13), and a fourth sub-pixel (14). The ratio of the aperture area of the fourth sub-pixel (14) to the aperture area of the red sub-pixel (11) is greater than 0.4, and the full width at half maximum of the emission peak in the emission spectrum of the fourth sub-pixel (14) is less than 60 nm, thereby enhancing the adjustment effect of the fourth sub-pixel (14) on the display panel and further improving the overall display performance of the display panel.

## Description

### TECHNICAL FIELD

The present application relates to the field of display technologies, and in particular, to a display panel.

### BACKGROUND

The existing organic light-emitting diode (OLED) display panels generally adopt three sub-pixels of red (R), green (G), and blue (B) to form a basic pixel unit, so as to achieve full-color display. In order to improve the display performance, the industry has gradually begun to attempt adding a fourth sub-pixel in addition to the above three sub-pixels, for compensating and adjusting the overall display effect. However, in the related art, the pixel design scheme for sub-pixels after the addition of the fourth sub-pixel is still immature, and the overall improvement in display performance is limited, making it difficult for the overall display effect to reach the expected optimization target.

### SUMMARY

The invention is set forth in the appended set of claims.

Embodiments of the present application provide a display panel, so as to enhance the adjustment effect of the fourth sub-pixel on the display panel, and thereby improve the overall display effect of the display panel.

In order to achieve the above object, according to a first aspect of the present application, a display panel is provided. The display panel includes a plurality of pixel units, and each of the pixel units includes a red sub-pixel, a green sub-pixel, a blue sub-pixel, and a fourth sub-pixel;
where a ratio of an aperture area of the fourth sub-pixel to an aperture area of the red sub-pixel is greater than 0.4, and a full width at half maximum of an emission peak in an emission spectrum of the fourth sub-pixel is less than 60 nm.

Optionally, a ratio of the aperture area of the red sub-pixel, an aperture area of the green sub-pixel, and an aperture area of the blue sub-pixel is 1:(0.7-1.3):(0.8-2.8); and/or
the ratio of the aperture area of the fourth sub-pixel to the aperture area of the red sub-pixel is less than or equal to 2.5; and/or
the full width at half maximum of the emission peak in the emission spectrum of the fourth sub-pixel is greater than or equal to 18 nm and less than or equal to 35 nm.

Optionally, a ratio of the aperture area of the red sub-pixel, an aperture area of the green sub-pixel, and an aperture area of the blue sub-pixel is 1:(0.8-1.0):(1.5-1.8); and/or
the ratio of the aperture area of the fourth sub-pixel to the aperture area of the red sub-pixel is greater than or equal to 0.7 and less than or equal to 1.8.

Optionally, a minimum value among an absolute value of a difference between a peak wavelength of the emission spectrum of the fourth sub-pixel and a peak wavelength of an emission spectrum of the red sub-pixel, an absolute value of a difference between the peak wavelength of the emission spectrum of the fourth sub-pixel and a peak wavelength of an emission spectrum of the green sub-pixel, and an absolute value of a difference between the peak wavelength of the emission spectrum of the fourth sub-pixel and a peak wavelength of an emission spectrum of the blue sub-pixel is greater than or equal to 5 nm.

Optionally, a peak wavelength of the emission spectrum of the fourth sub-pixel is located in a red light wavelength band and is greater than a peak wavelength of an emission spectrum of the red sub-pixel. Alternatively, a peak wavelength of the emission spectrum of the fourth sub-pixel is located in a cyan light wavelength band.

Optionally, a peak wavelength of the emission spectrum of the fourth sub-pixel is located in a cyan light wavelength band, and a difference between the peak wavelength of the emission spectrum of the fourth sub-pixel and a peak wavelength of an emission spectrum of the blue sub-pixel is less than a difference between a peak wavelength of an emission spectrum of the green sub-pixel and the peak wavelength of the emission spectrum of the fourth sub-pixel.

Optionally, a peak wavelength of the emission spectrum of the fourth sub-pixel is located in a cyan light wavelength band, and the emission spectrum of the fourth sub-pixel satisfies at least one of conditions (a)-(d):
(a) a difference between the peak wavelength of the emission spectrum of the fourth sub-pixel and a peak wavelength of an emission spectrum of the blue sub-pixel is less than or equal to 15 nm;
(b) a difference between a peak wavelength of an emission spectrum of the green sub-pixel and the peak wavelength of the emission spectrum of the fourth sub-pixel is greater than or equal to 50 nm and less than or equal to 60 nm;
(c) the full width at half maximum of the emission peak in the emission spectrum of the fourth sub-pixel is less than or equal to 28 nm;
(d) the peak wavelength of the emission spectrum of the fourth sub-pixel is greater than or equal to 465 nm and less than or equal to 475 nm.

Optionally, a peak wavelength of the emission spectrum of the fourth sub-pixel is located in a red light wavelength band, and emission spectra of sub-pixels in each of the plurality of pixel units satisfy at least one of conditions (e)-(h):
(e) a difference between the peak wavelength of the emission spectrum of the fourth sub-pixel and a peak wavelength of an emission spectrum of the red sub-pixel is greater than or equal to 15 nm and less than or equal to 30 nm;
(f) a peak wavelength of an emission spectrum of the red sub-pixel is greater than or equal to 620 nm and less than or equal to 630 nm;
(g) the peak wavelength of the emission spectrum of the fourth sub-pixel is greater than or equal to 640 nm and less than or equal to 655 nm;
(h) the full width at half maximum of the emission peak in the emission spectrum of the fourth sub-pixel is less than or equal to 35 nm.

Optionally, the aperture area of the fourth sub-pixel is less than or equal to the aperture area of the red sub-pixel and/or the aperture area of the fourth sub-pixel is less than or equal to an aperture area of the green sub-pixel.

Optionally, the ratio of the aperture area of the fourth sub-pixel to the aperture area of the red sub-pixel is less than or equal to 0.8.

Optionally, a peak wavelength of the emission spectrum of the fourth sub-pixel is in a blue light wavelength band, and a current efficiency of the fourth sub-pixel is greater than a current efficiency of the blue sub-pixel.

Optionally, an absolute value of a difference between the peak wavelength of the emission spectrum of the fourth sub-pixel and a peak wavelength of an emission spectrum of the blue sub-pixel is less than or equal to 2 nm; and/or
a ratio of the current efficiency of the fourth sub-pixel to the current efficiency of the blue sub-pixel is greater than or equal to 1.1; and/or
the full width at half maximum of the emission peak in the emission spectrum of the fourth sub-pixel is less than or equal to 21 nm; and/or
the aperture area of the fourth sub-pixel is greater than the aperture area of the red sub-pixel; and/or
the aperture area of the fourth sub-pixel is greater than an aperture area of the green sub-pixel.

Optionally, the aperture area of the fourth sub-pixel is greater than an aperture area of the blue sub-pixel; and/or
a ratio of the current efficiency of the fourth sub-pixel to the current efficiency of the blue sub-pixel is greater than or equal to 2.2.

The embodiments of the present application provide a display panel. The display panel includes a plurality of pixel units, each pixel unit including a red sub-pixel, a green sub-pixel, a blue sub-pixel, and a fourth sub-pixel. The ratio of the aperture area of the fourth sub-pixel to the aperture area of the red sub-pixel is greater than 0.4, so as to increase an effective light-emitting area of the fourth sub-pixel and thereby enhance a display contribution of the fourth sub-pixel. The full width at half maximum of the emission peak in the emission spectrum of the fourth sub-pixel is less than 60 nm, so that the fourth sub-pixel has a relatively narrow emission peak, thereby improving color purity and reducing overlap with emission wavelength bands of adjacent sub-pixels.

Through the above structural design, the embodiments of the present application can improve the adjustment effect of the fourth sub-pixel on the display panel, thereby enhancing the display effect of the display panel.

Other features and advantages of the present application will be described in detail in the following detailed description.

### BRIEF DESCRIPTION OF THE DRAWINGS

In order to describe the embodiments of the present application more clearly, accompanying drawings to be used in the description of the embodiments of the present application will be briefly introduced below. It is apparent that the drawings in the following description are merely some embodiments of the present application. For those skilled in the art, other drawings can be obtained from these drawings without involving inventive effort.

In order to fully understand the present application and beneficial effects thereof, the description will be given below in conjunction with the drawings, and the same reference numerals in the description below represent the same parts in the drawings.
FIG. 1 is a first top view of a display panel according to an exemplary embodiment of the present application.
FIG. 2 is a second top view of the display panel according to an exemplary embodiment of the present application.
FIG. 3 is a cross-sectional view of the display panel according to an exemplary embodiment of the present application.
FIG. 4 is another cross-sectional view of the display panel according to an exemplary embodiment of the present application.
FIG. 5 is a color gamut coverage diagram of the display panels according to Exemplary Examples 1 to 4 of the present application.

Reference numerals:
100, display panel; 1, pixel unit; 11, red sub-pixel; 12, green sub-pixel; 13, blue sub-pixel; 14, fourth sub-pixel; 2, pixel definition layer; 21, bank structure; 22, pixel opening; 221, bottom opening; 222, top opening; 3, substrate; 4, electrode layer; 41, first electrode unit; 5, light-emitting device; 51, hole injection layer; 52, hole transport layer; 53, light-emitting layer; 54, electron functional layer; 55, second electrode; 6, encapsulation structure.

### DETAILED DESCRIPTION

The embodiments of the present application will be clearly and completely described with reference to the accompanying drawings of the present application. It is apparent that the described embodiments are only some of the embodiments of the present application, rather than all of the embodiments. According to the embodiments of the present application, all other embodiments obtained by those skilled in the art without involving any inventive effort shall fall within the scope of the present application.

In order to improve the display performance, the industry has gradually begun to attempt adding a fourth sub-pixel in addition to the above three sub-pixels, for compensating and adjusting the overall display effect. However, in the related art, the pixel design scheme for sub-pixels after the addition of the fourth sub-pixel is still immature, and the overall improvement in display performance is limited, making it difficult for the overall display effect to reach the expected optimization target.

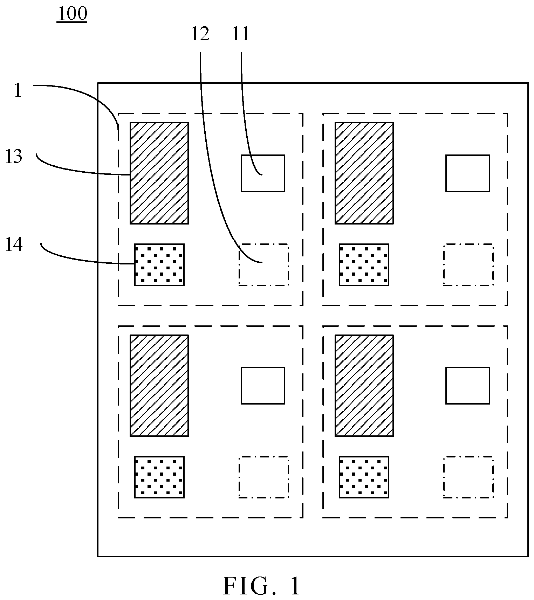

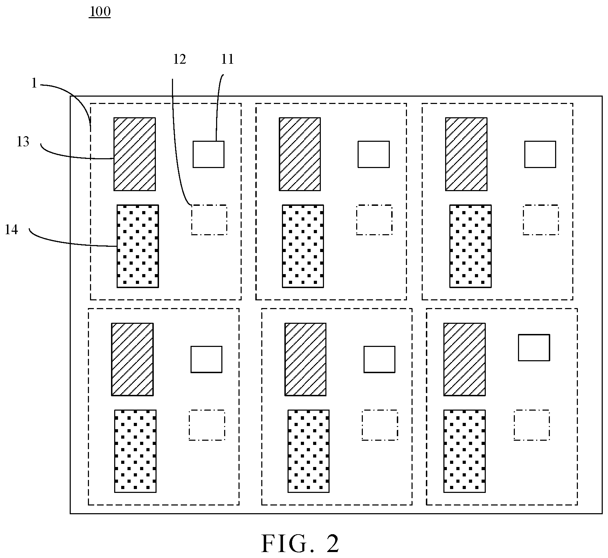

Referring to FIG. 1 and FIG. 2, some embodiments of the present application provide a display panel 100. The display panel 100 includes a plurality of pixel units 1, and each pixel unit 1 includes a red sub-pixel 11, a green sub-pixel 12, a blue sub-pixel 13, and a fourth sub-pixel 14.

The ratio of an aperture area of the fourth sub-pixel 14 to an aperture area of the red sub-pixel 11 is greater than 0.4. By increasing an effective light-emitting area of the fourth sub-pixel 14, a display contribution of the fourth sub-pixel 14 is improved. An emission peak in an emission spectrum of the fourth sub-pixel 14 has a full width at half maximum of less than 60 nm, such that the fourth sub-pixel 14 has a relatively narrow emission peak, thereby improving color purity and reducing overlap with emission spectral bands of adjacent sub-pixels.

In the embodiments of the present application, the aperture area of a sub-pixel refers to an actual area within an effective light-emitting region of the pixel unit 1 that is capable of transmitting or emitting light. The aperture area generally does not include regions occupied by structures such as metal wirings, light-shielding layers, and partition walls that do not participate in light emission or that block light, and only the effective optical window used for display imaging in the sub-pixel is counted.

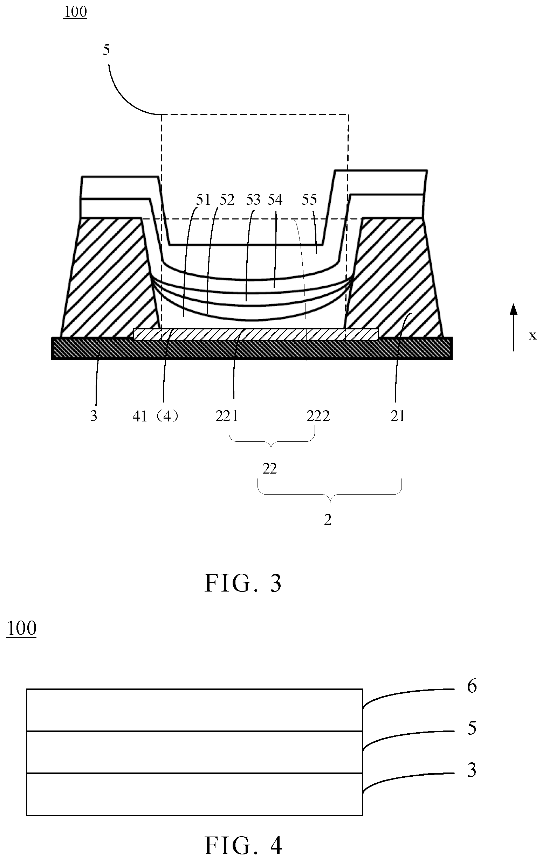

Referring to FIG. 3, in some embodiments, the display panel 100 includes a pixel definition layer 2 and an electrode layer 4 that is stacked with the pixel definition layer 2 on a side opposite to a light-emitting direction. The pixel definition layer 2 includes a plurality of bank structures 21 that are spaced apart from each other, and a pixel opening 22 is formed between two adjacent bank structures 21. The pixel opening 22 corresponds to and exposes a first electrode unit 41 located within the electrode layer 4, and the pixel opening 22 extends along the light-emitting direction so as to penetrate through the pixel definition layer 2 in a thickness direction thereof, thereby forming a bottom opening 221 and a top opening 222 that are sequentially arranged along the light-emitting direction x. In some embodiments of the present application, an area of the bottom opening 221 is equal to an area of the pixel opening 22. However, it should be understood that, if there is a non-light-transmitting region at the bottom opening 221, such a non-light-transmitting region is not included in the statistical range of the aperture area of the sub-pixel.

In some embodiments, the display panel includes an array substrate. The array substrate includes a substrate 3, thin film transistors, a wiring layer, and the electrode layer 4 as described in the foregoing embodiments. The substrate 3 is a glass substrate or a flexible polymer substrate, and is configured to carry functional structures such as the thin film transistors, the wiring layer, and the electrode layer 4. The electrode layer 4 is formed on a surface of the substrate 3 and is electrically connected to a driving circuit constituted by the thin film transistors. In some embodiments, each sub-pixel includes a light-emitting device 5. The light-emitting device 5 includes the first electrode unit 41 as described in the foregoing embodiments, a second electrode 55 disposed opposite to the first electrode unit 41, and an organic functional layer located between the first electrode unit 41 and the second electrode 55.

In a specific embodiment, the organic functional layer includes a hole functional layer, a light-emitting layer 53, and an electron functional layer 54, which are stacked in sequence along the light-emitting direction. The hole functional layer includes a hole injection layer 51 and a hole transport layer 52 that are stacked in sequence along the light-emitting direction. The electron functional layer 54 includes an electron transport layer (not shown in the figure) and an electron injection layer (not shown in the figure) that are stacked in sequence along the light-emitting direction.

It should be noted that the method for testing the full width at half maximum described in the embodiments of the present application is as follows. A display panel to be tested is placed in a sealed darkroom, where an ambient temperature is set to 25°C ± 2°C and a relative humidity is ≤ 60%. Before spectral data acquisition, a dark baseline correction is performed on a spectro-radiometer. A high-precision constant current source is used to drive and light up a target sub-pixel with a direct current at a current density of 10 mA/cm². A pinhole aperture is mounted at a front end of an optical fiber probe so as to limit a field of view for acquisition to cover only a single target sub-pixel. The probe is kept perpendicular to a light-emitting surface of the sub-pixel, with a light-receiving half-angle of ≤ 2°, and a distance between the probe and the light-emitting surface is fixed at 5 mm. After a driving current is applied and emission and temperature of the device become stable, a spectro-radiometer having a model number CS2000A and a spectral resolution of ≤ 1 nm is used to integrally acquire light emitted from the sub-pixel with fixed scanning step length, integration time, and number of scan averages, thereby obtaining an original electroluminescence spectrum. The full width at half maximum of the spectrum is calculated by uniformly adopting the original spectrum without additional smoothing, and determining a wavelength difference corresponding to 1/2 of a peak intensity.

In some embodiments, the ratio of the aperture area of the red sub-pixel 11, the aperture area of the green sub-pixel 12, and the aperture area of the blue sub-pixel 13 is 1:(0.7-1.3):(0.8-2.8). In this way, the color gamut coverage of the display panel 100 can be improved and/or power consumption of the display panel 100 can be reduced.

In some embodiments, the ratio of the aperture area of the red sub-pixel 11, the aperture area of the green sub-pixel 12, and the aperture area of the blue sub-pixel 13 is preferably 1:(0.8-1.0):(1.5-1.8). When the ratio of these aperture areas falls within this preferred range, the aperture area of the blue sub-pixel 13 is larger relative to the red sub-pixel 11 and green sub-pixel 12, which can compensate for relatively low luminous efficiency and lifetime of blue light-emitting materials, thereby increasing blue luminance while suppressing an excessively high driving current.

In some embodiments, the ratio of the aperture area of the fourth sub-pixel 14 to the aperture area of the red sub-pixel 11 is less than or equal to 2.5, so as to ensure that the fourth sub-pixel 14, while providing additional display functions, does not adversely affect the color gamut and/or power consumption of display functions. In some preferred embodiments, the ratio of the aperture area of the fourth sub-pixel 14 to the aperture area of the red sub-pixel 11 is greater than or equal to 0.7 and less than or equal to 1.8.

In some embodiments, a minimum value among an absolute value of a difference between the peak wavelength of the emission spectrum of the fourth sub-pixel 14 and the peak wavelength of the emission spectrum of the red sub-pixel 11, an absolute value of a difference between the peak wavelength of the emission spectrum of the fourth sub-pixel 14 and the peak wavelength of the emission spectrum of the green sub-pixel 12, and an absolute value of a difference between the peak wavelength of the emission spectrum of the fourth sub-pixel 14 and the peak wavelength of the emission spectrum of the blue sub-pixel 13 is greater than or equal to 5 nm. In this way, the emission spectrum of the fourth sub-pixel 14 has a predetermined spectral interval, in terms of wavelength position, relative to the emission spectra of the red sub-pixel 11, the green sub-pixel 12, and the blue sub-pixel 13, thereby reducing spectral overlap among different sub-pixels and improving color gamut coverage.

In some embodiments, the peak wavelength of the emission spectrum of the fourth sub-pixel 14 is located in a cyan light wavelength band, for example, the peak wavelength is greater than or equal to 465 nm and less than or equal to 505 nm. In this way, a transition color is formed between blue and green, thereby enriching color gamut performance of the display panel 100 and improving color reproduction.

In some embodiments, the peak wavelength of the emission spectrum of the fourth sub-pixel 14 is located in a cyan light wavelength band, and the difference between the peak wavelength of the emission spectrum of the fourth sub-pixel 14 and the peak wavelength of the emission spectrum of the blue sub-pixel 13 is less than the difference between the peak wavelength of the emission spectrum of the green sub-pixel 12 and the peak wavelength of the emission spectrum of the fourth sub-pixel 14. Through the above relationship, the fourth sub-pixel 14 is closer to the blue sub-pixel in chromaticity coordinates, thereby enhancing color gradation in a blue-green transition region while maintaining blue display brightness, improving display effects of high-brightness regions or scenes such as water and sky, and contributing to an improvement in overall display quality without significantly increasing driving complexity. In some preferred embodiments, the peak wavelength of the emission spectrum of the fourth sub-pixel 14 is greater than or equal to 470 nm and less than or equal to 475 nm.

In some embodiments, the peak wavelength of the emission spectrum of the blue sub-pixel 13 is greater than or equal to 450 nm and less than 465 nm. In this way, while ensuring display brightness and color purity of blue light, a reasonable spectral interval is reserved for the cyan peak wavelength of the emission spectrum of the fourth sub-pixel 14, thereby achieving a more favorable chromaticity matching relationship and better visual display effects.

In some embodiments, the peak wavelength of the emission spectrum of the green sub-pixel 12 is greater than or equal to 525 nm and less than or equal to 535 nm. By controlling the peak wavelength of the green sub-pixel 12 within this range, a reasonable spectral distribution interval can be formed with the blue sub-pixel 13 and the fourth sub-pixel 14 while maintaining display brightness and color purity of green light, such that the blue sub-pixel, cyan sub-pixel, and green sub-pixel 12 form an expanded color gamut triangular region on a CIE chromaticity diagram, thereby further improving color gamut coverage and color reproduction capability of the display panel 100.

In some embodiments, the difference between the peak wavelength of the emission spectrum of the fourth sub-pixel 14 and the peak wavelength of the emission spectrum of the blue sub-pixel 13 is greater than or equal to 10 nm and less than or equal to 15 nm, so as to form a moderate spectral interval between blue and cyan, thereby avoiding excessively close peak positions that would cause severe spectral overlap, and also avoiding an excessively large interval that would result in discontinuous chromaticity distribution.

In some embodiments, the difference between the peak wavelength of the emission spectrum of the green sub-pixel 12 and the peak wavelength of the emission spectrum of the fourth sub-pixel 14 is greater than or equal to 10 nm, such that the cyan sub-pixel forms a stable and distinguishable emission peak on a short-wavelength side of the green sub-pixel 12, thereby stretching a boundary in a green direction in a chromaticity space and increasing an overall color gamut area. In some preferred embodiments, the difference between the peak wavelength of the emission spectrum of the green sub-pixel 12 and the peak wavelength of the emission spectrum of the fourth sub-pixel 14 is greater than or equal to 50 nm and less than or equal to 60 nm, thereby further increasing the overall color gamut area.

In some embodiments, the full width at half maximum of the emission peak in the emission spectrum of the fourth sub-pixel 14 is less than or equal to 45 nm. For example, the full width at half maximum of the emission peak in the emission spectrum of the fourth sub-pixel 14 may be in a range from 15 nm to 45 nm; alternatively, the full width at half maximum of the emission peak in the emission spectrum of the fourth sub-pixel 14 may be in a range from 18 nm to 45 nm. In this way, the fourth sub-pixel 14 is provided with relatively narrow-band emission characteristics, reducing extension of its emission spectrum into adjacent wavelength bands, further suppressing overlap with emission spectra of the red sub-pixel 11, the green sub-pixel 12, and the blue sub-pixel 13, and improving color purity and display contrast. In some preferred embodiments, the full width at half maximum of the emission peak in the emission spectrum of the fourth sub-pixel 14 is less than or equal to 35 nm, for example, the full width at half maximum of the emission peak in the emission spectrum of the fourth sub-pixel 14 is in a range from 18 nm to 35 nm. In some more preferred embodiments, the full width at half maximum of the emission peak in the emission spectrum of the fourth sub-pixel 14 is less than or equal to 28 nm.

In some embodiments, the aperture area of the fourth sub-pixel 14 is less than or equal to the aperture area of the green sub-pixel 12. This can avoid excessively strong interference of the fourth sub-pixel 14 with a main green luminance channel during high-brightness display or composite color output, thereby maintaining the dominant role of the green sub-pixel 12 in luminance contribution and in the region of visual sensitivity of the human eye. At the same time, it reduces color coordinate shift caused by excessive emission of the fourth sub-pixel 14, and, while expanding the color gamut in a blue-cyan region, improves white balance stability and composite color accuracy.

In some embodiments, the aperture area of the fourth sub-pixel 14 is less than the aperture area of the red sub-pixel 11 and less than the aperture area of the green sub-pixel 12. By constraining the aperture area of the fourth sub-pixel 14 to be less than those of both the the red sub-pixel 11 and green sub-pixel 12, a proportion of the fourth sub-pixel 14 in overall luminous flux can be further controlled, thereby reducing its disturbance to luminance and chromaticity of main color channels, and thus balancing high color-gamut display requirements with color consistency and display stability of the panel.

The present application provides display panels 100 according to Examples 1 to 3 and Comparative Example 1. In the display panel 100 of each of Examples 1 to 3 and Comparative Example 1, a plurality of pixel units 1 are included, and each pixel unit 1 includes a red sub-pixel 11, a green sub-pixel 12, a blue sub-pixel 13, and a fourth sub-pixel 14. The parameters of the fourth sub-pixel 14 in the display panel 100 of Examples 1 to 3 and Comparative Example 1 are shown in Table 1. In Tables 1 to 3 of the present application, "FWHM" is an abbreviation for "full width at half maximum."

**Table 1**

| | Sub-pixel | Peak Wavelength of Emission Spectrum | FWHM | Ratio of Aperture Areas | Color Gamut Improvement Percentage (%) |
|---|---|---|---|---|---|
| Example 1 | R | 625 nm | 33 nm | 1 | 20 |
| | G | 525 nm | 26 nm | 0.9 | |
| | B | 460 nm | 20 nm | 1.8 | |
| | C | 465 nm | 28 nm | 0.8 | |
| Example 2 | R | 625 nm | 33 nm | 1 | 22 |
| | G | 525 nm | 26 nm | 0.9 | |
| | B | 460 nm | 20 nm | 1.8 | |
| | C | 470 nm | 22 nm | 0.8 | |
| Example 3 | R | 625 nm | 33 nm | 1 | 25 |
| | G | 525 nm | 26 nm | 0.9 | |
| | B | 460 nm | 20 nm | 1.8 | |
| | C | 475 nm | 20 nm | 0.8 | |
| Comparative Example 1 | R | 625 nm | 33 nm | 1 | 5 |
| | G | 525 nm | 26 nm | 0.9 | |
| | B | 460 nm | 20 nm | 1.8 | |
| | C | 520 nm | 65 nm | 0.3 | |

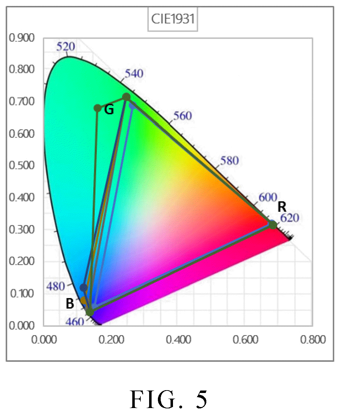

It can be understood that the percentage increase in color gamut coverage is defined as the ratio of the color gamut coverage area of the four sub-pixels of each display panel 100 to the color gamut coverage area of the RGB sub-pixels of the display panel 100. The schematic diagrams of the color gamut coverage for Examples 1 to 4 are shown in FIG. 5.

From the data in Table 1, it can be seen that when the ratio of the aperture area of the fourth sub-pixel 14 to the aperture area of the red sub-pixel 11 is greater than 0.4, and the full width at half maximum of the emission peak in the emission spectrum of the fourth sub-pixel 14 is less than 60 nm, the increase in the color gamut coverage area is greater than or equal to 20%. Furthermore, as the full width at half maximum of the emission peak decreases, the color gamut coverage is further improved. When the difference between the peak wavelength of the emission spectrum of the blue sub-pixel 13 and that of the fourth sub-pixel 14 is greater than 10 nm and less than 15 nm, the increase in color gamut coverage is even larger.

In other embodiments, the peak wavelength of the emission spectrum of the fourth sub-pixel 14 is located in a red light wavelength band and is greater than the peak wavelength of the emission spectrum of the red sub-pixel 11. By setting the peak wavelength of the fourth sub-pixel 14 on the long-wavelength side of the peak wavelength of the red sub-pixel 11, the representable color gamut range in the red region can be expanded, thereby further enhancing the display capability of deep red or long-wavelength-leaning red. This is beneficial for presenting richer and more gradated red images, and thus improves the color gamut coverage of the display device.

In some embodiments, the difference between the peak wavelength of the emission spectrum of the fourth sub-pixel 14 and the peak wavelength of the emission spectrum of the red sub-pixel 11 is greater than or equal to 15 nm and less than or equal to 20 nm. In this way, by shifting the peak wavelength of the fourth sub-pixel 14 by 15-20 nm toward the long-wavelength side relative to the red sub-pixel 11, the chromaticity coordinates of the red sub-pixel 11 can be kept substantially stable, while the position of the fourth sub-pixel 14 in the chromaticity diagram moves toward deeper red or near-infrared. As a result, the overall color gamut range is expanded without significantly affecting the subjective perception of brightness and chromaticity by the human eye.

In some embodiments, the peak wavelength of the emission spectrum of the red sub-pixel 11 is greater than or equal to 610 nm and less than or equal to 635 nm. In some preferred embodiments, the peak wavelength of the emission spectrum of the red sub-pixel 11 is greater than or equal to 620 nm and less than or equal to 630 nm. By limiting the peak wavelength of the red sub-pixel 11 within the above ranges, it can be ensured that the light output by the red sub-pixel 11 falls within a wavelength interval where human visual sensitivity is relatively high and which is suitable as a standard red reference. This is conducive to obtaining stable red chromaticity coordinates and forming a reasonable three-primary-color configuration together with the peak wavelengths of the green sub-pixel 12 and the blue sub-pixel.

In some embodiments, the peak wavelength of the emission spectrum of the fourth sub-pixel 14 is greater than 635 nm and less than or equal to 680 nm. In some preferred embodiments, the peak wavelength of the emission spectrum of the fourth sub-pixel 14 is less than or equal to 665 nm. For example, the peak wavelength of the emission spectrum of the fourth sub-pixel 14 is greater than or equal to 640 nm and less than or equal to 645 nm. By limiting the peak wavelength of the fourth sub-pixel 14 within the above ranges, the peak wavelength of the fourth sub-pixel 14 is further shifted toward the long-wavelength side relative to the red sub-pixel 11, thereby extending into a deeper red region. This helps enhance the display apparatus's capability to represent deep red colors and improves the distinguishability between low-saturation red and high-saturation red.

In some embodiments, the full width at half maximum of the emission peak in the emission spectrum of the fourth sub-pixel 14 is less than or equal to 45 nm, for example, the full width at half maximum of the emission peak in the emission spectrum of the fourth sub-pixel 14 is in the range of 15 nm to 45 nm. By controlling the full width at half maximum of the emission peak of the fourth sub-pixel 14 within the above range, the bandwidth of the emission spectrum of the fourth sub-pixel 14 can be reduced, thereby narrowing its emission spectrum and further decreasing the degree of spectral overlap, in terms of wavelength, with the emission spectra of the red sub-pixel 11, the green sub-pixel 12, and the blue sub-pixel 13. This is beneficial for suppressing crosstalk between different channels and improving color purity and chromaticity stability. In some preferred embodiments, the full width at half maximum of the emission peak in the emission spectrum of the fourth sub-pixel 14 is less than or equal to 35 nm.

In some embodiments, the aperture area of the fourth sub-pixel 14 is less than or equal to the aperture area of the red sub-pixel 11. This can prevent the fourth sub-pixel 14 from occupying an excessively high weight in the overall composite color, thereby reducing its impact on white point balance and color accuracy and avoiding composite color shift caused by an excessively high proportion of light emission from the fourth sub-pixel 14. At the same time, while ensuring that the fourth sub-pixel 14 participates in expanding the color gamut, this is conducive to maintaining the luminance contribution of the red sub-pixel 11 and its capability to display highly saturated red, thereby achieving both a wide color gamut display effect and stability of the overall composite color.

In some embodiments, the aperture area of the fourth sub-pixel 14 is less than the aperture area of the red sub-pixel 11 and less than the aperture area of the green sub-pixel 12. By simultaneously limiting the aperture area of the fourth sub-pixel 14 to be less than that of the red sub-pixel 11 and the green sub-pixel 12, excessive interference of the fourth sub-pixel 14 with the luminance and chromaticity distribution of the three primary color sub-pixels can be further suppressed, so that it functions more as a sub-pixel for auxiliary color gamut expansion and enhancement of display performance in specific luminance ranges, without changing the dominant roles of the red and green sub-pixels in color mixing. As a result, the color consistency and display reliability of the display panel under different gray levels and different scenarios can be improved.

In the embodiments of the present application, when the emission peak of the fourth sub-pixel 14 is located in the red light wavelength band, the fourth sub-pixel 14 may be configured to emit light synchronously with the red sub-pixel 11 when displaying a red image or an image containing a red component, so as to jointly output red light and thereby increase the luminance and color saturation of red display. Alternatively, the fourth sub-pixel 14 may be configured not to emit light simultaneously with the red sub-pixel 11, thereby enabling fine adjustment of the luminance and chromaticity of red light or expansion of the color gamut, and thus improving the overall display performance and flexibility of the display apparatus.

The present application provides display panels 100 according to Examples 4 to 6 and Comparative Example 2.

In the display panel 100 of each of Examples 4 to 6 and Comparative Example 2, a plurality of pixel units 1 are included, and each pixel unit 1 includes a red sub-pixel 11, a green sub-pixel 12, a blue sub-pixel 13, and a fourth sub-pixel 14. The parameters of the fourth sub-pixel 14 in the display panel 100 of Examples 4 to 6 and Comparative Example 2 are shown in Table 2.

**Table 2**

| | Sub-pixel | Peak Wavelength of Emission Spectrum | FWHM | Ratio of Aperture Areas | Color Gamut Improvement Percentage (%) |
|---|---|---|---|---|---|
| Example 4 | R | 625 nm | 33 nm | 1 | 10 |
| | G | 525 nm | 26 nm | 0.9 | |
| | B | 460 nm | 20 nm | 1.8 | |
| | X | 640 nm | 35 nm | 0.7 | |
| Example 5 | R | 625 nm | 33 nm | 1 | 12 |
| | G | 525 nm | 26 nm | 0.9 | |
| | B | 460 nm | 20 nm | 1.8 | |
| | X | 640 nm | 30 nm | 0.7 | |
| Example 6 | R | 625 nm | 33 nm | 1 | 15 |
| | G | 525 nm | 26 nm | 0.9 | |
| | B | 460 nm | 20 nm | 1.8 | |
| | X | 655 nm | 30 nm | 0.7 | |
| Comparative Example 2 | R | 625 nm | 33 nm | 1 | 3 |
| | G | 525 nm | 26 nm | 0.9 | |
| | B | 460 nm | 20 nm | 1.8 | |
| | X | 630 nm | 70 nm | 0.4 | |

It can be understood that the percentage increase in color gamut coverage is defined as the ratio of the color gamut coverage area of the four sub-pixels of each display panel 100 to the color gamut coverage area of the RGB sub-pixels of the display panel 100.

From the data in Table 2, it can be seen that when the ratio of the aperture area of the fourth sub-pixel 14 to the aperture area of the red sub-pixel 11 is greater than 0.4, and the full width at half maximum of the emission peak in the emission spectrum of the fourth sub-pixel 14 is less than 60 nm, the increase in the color gamut coverage area is greater than or equal to 10%. Furthermore, when the emission peak of the fourth sub-pixel 14 is located in the deep-red wavelength band, the smaller the full width at half maximum of the emission peak, the further the color gamut coverage is improved. Furthermore, when the full width at half maximum of the emission peak of the fourth sub-pixel 14 is less than 35 nm, and the wavelength difference between the emission peak of the fourth sub-pixel 14 and the emission peak of the red sub-pixel 11 is greater than 15 nm, the color gamut coverage is further improved.

In other embodiments, the peak wavelength of the emission spectrum of the fourth sub-pixel 14 is located in the blue light wavelength band, and the current efficiency of the fourth sub-pixel 14 is higher than the current efficiency of the blue sub-pixel 13. By configuring the fourth sub-pixel 14 to emit light in the blue light wavelength band and making its current efficiency higher than that of the blue sub-pixel 13, the fourth sub-pixel 14 can provide higher-efficiency blue light emission in the display panel 100, thereby reducing the driving current, driving power consumption, and resultant heat generation during blue light display while achieving the same brightness output. At the same time, in a white display mode, the fourth sub-pixel 14 can cooperate with the blue sub-pixel 13 to emit blue light in different blue wavelength ranges, thereby enabling proportioning and adjustment of the blue light component and reducing energy consumption in white display.

It can be understood that, in the display panel 100 provided in the embodiments of the present application, its driving strategy can be dynamically adjusted according to different display states. The white display state may correspond to white-background interfaces, grayscale gradients, human skin tones, and multi-color mixed images. In this state, by adjusting the brightness output ratio of the various color sub-pixels, the mixed display image can present a target white-field effect and, in combination with overall brightness control, achieve adjustment of the brightness levels of the image. Conversely, the pure-color display state can be used to display highly saturated single-color images, including pure red, pure green, pure blue images, monochrome icons, or color test images. In this state, the display panel 100 may mainly drive the sub-pixels corresponding to the target color to emit light, while reducing or turning off the light emission output of sub-pixels of other colors, thereby reducing cross-channel color coupling. In the embodiments of the present application, the fourth sub-pixel 14 and the blue sub-pixel 13 may be configured to emit light simultaneously in the white display state of the display panel 100, so as to jointly contribute to the blue light output of the white-field image. Alternatively, the fourth sub-pixel 14 may be configured to emit light only in the white display state, and the blue sub-pixel 13 may be configured to emit light only in the pure-color display state.

In some embodiments, the ratio of the current efficiency of the fourth sub-pixel 14 to the current efficiency of the blue sub-pixel 13 is greater than or equal to 1.1. In other words, under the same driving current conditions, the light output generated by the fourth sub-pixel 14 is at least 1.1 times the light output of the blue sub-pixel 13. By enabling the fourth sub-pixel 14 to have a relatively higher current efficiency, the required blue-light brightness and chromaticity can be achieved without significantly increasing the overall driving current, and the current load of the blue sub-pixel 13 can be reduced to a certain extent, which is beneficial for slowing its degradation and improving the brightness retention and color stability of the display panel 100 over long-term use.

In some preferred embodiments, the ratio of the current efficiency of the fourth sub-pixel 14 to the current efficiency of the blue sub-pixel 13 is greater than or equal to 1.2. In some more preferred embodiments, the ratio of the current efficiency of the fourth sub-pixel 14 to the current efficiency of the blue sub-pixel 13 is greater than or equal to 2.2.

It can be understood that, in the embodiments of the present application, the current efficiency of a sub-pixel refers to the ratio between the luminous brightness generated per unit area of the sub-pixel and the actual current consumed by the sub-pixel, under preset driving voltage or driving current conditions.

In some embodiments, the absolute value of the difference between the peak wavelength of the emission spectrum of the fourth sub-pixel 14 and the peak wavelength of the emission spectrum of the blue sub-pixel 13 is less than or equal to 35 nm. By controlling the peak wavelengths of the two sub-pixels within a relatively small range, the fourth sub-pixel 14 and the blue sub-pixel 13 can exhibit high spectral consistency during light mixing, thereby reducing color deviation between different blue sub-pixels and improving chromaticity uniformity and display consistency in white-field display. Meanwhile, since their emission bands are close, brightness compensation or load distribution is less likely to cause significant shifts in the overall chromaticity coordinates, which is beneficial for enhancing the color stability of the display panel 100 under different gray levels, different display modes, and long-term usage conditions. In some preferred embodiments, the absolute value of the difference between the peak wavelength of the emission spectrum of the fourth sub-pixel 14 and the peak wavelength of the emission spectrum of the blue sub-pixel 13 is less than or equal to 10 nm. In some preferred embodiments, the absolute value of the difference between the peak wavelength of the emission spectrum of the fourth sub-pixel 14 and the peak wavelength of the emission spectrum of the blue sub-pixel 13 is less than or equal to 2 nm.

In some embodiments, the full width at half maximum of the emission peak in the emission spectrum of the fourth sub-pixel 14 is less than or equal to 50 nm, for example, the full width at half maximum of the emission peak is greater than or equal to 15 nm to 50 nm. By controlling the full width at half maximum within a relatively narrow range, the emission spectrum of the fourth sub-pixel 14 can be made more concentrated, thereby reducing interference from the spectral tail with other color sub-pixels, which is beneficial for improving the color gamut coverage and color purity of the display panel 100, and reducing chromaticity cross-talk under high-brightness white-field or mixed-color display scenarios. In some preferred embodiments, the full width at half maximum of the emission peak in the emission spectrum of the fourth sub-pixel 14 is greater than or equal to 10 nm and less than or equal to 35 nm. In some more preferred embodiments, the full width at half maximum of the emission peak in the emission spectrum of the fourth sub-pixel 14 is less than or equal to 21 nm.

In some embodiments, the aperture area of the fourth sub-pixel 14 is greater than the aperture area of the red sub-pixel 11 and/or the aperture area of the green sub-pixel 12. By increasing the aperture area of the fourth sub-pixel 14, higher light output can be obtained under the same driving current density, thereby improving the overall brightness of the panel without significantly increasing power consumption and device thermal load. In further embodiments, the aperture area of the fourth sub-pixel 14 is greater than the aperture area of the blue sub-pixel 13, such that, in white display, the brightness allocation strategy can preferentially assign a portion of the blue light to be emitted by the fourth sub-pixel 14, thereby reducing the operating load of the other blue sub-pixels and extending their service life.

In the display panel 100 of each of Examples 7 to 9 and Comparative Example 3, a plurality of pixel units 1 are included, and each pixel unit 1 includes a red sub-pixel 11, a green sub-pixel 12, a blue sub-pixel 13, and a fourth sub-pixel 14. The parameters of the fourth sub-pixel 14 in the display panel 100 of Examples 7 to 9 and Comparative Example 3 are shown in Table 3.

**Table 3**

| | Sub-pixel | Peak Wavelength of Emission Spectrum | FWHM | Ratio of Aperture Areas | Current Efficiency (cd/A) | Power Consumption Reduction Percentage (%) |
|---|---|---|---|---|---|---|
| Example 7 | R | 625 nm | 33 nm | 1 | / | 10 |
| | G | 525 nm | 26 nm | 0.9 | / | |
| | B | 460 nm | 20 nm | 1.5 | 10 | |
| | X | 461 nm | 21 nm | 1.2 | 20 | |
| Example 8 | R | 625 nm | 33 nm | 1 | / | 11 |
| | G | 525 nm | 26 nm | 0.9 | / | |
| | B | 460 nm | 20 nm | 1.5 | 10 | |
| | X | 462 nm | 21 nm | 1.2 | 22 | |
| Example 9 | R | 625 nm | 33 nm | 1 | / | 13 |
| | G | 525 nm | 26 nm | 0.9 | / | |
| | B | 460 nm | 20 nm | 1.5 | 10 | |
| | X | 461 nm | 18 nm | 1.2 | 25 | |
| Example 10 | R | 625 nm | 33 nm | 1 | / | 20 |
| | G | 525 nm | 26 nm | 0.9 | / | |
| | B | 460 nm | 20 nm | 1.5 | 10 | |
| | X | 461 nm | 18 nm | 1.8 | 25 | |
| Comparati ve Example 3 | R | 625 nm | 33 nm | 1 | / | 5 |
| | G | 525 nm | 26 nm | 0.9 | / | |
| | B | 460 nm | 20 nm | 1.5 | 10 | |
| | X | 459 nm | 60 nm | 0.4 | 16 | |

As shown in Table 3, at a white luminance of 850 nits, the current density of blue light in Example 10 is reduced by 15% compared with Example 9, while the lifetime is increased by 20%. In Comparative Example 3, at a white luminance of 850 nits, the current density of blue light is increased by 10% compared with Example 9, and the lifetime is reduced by 15%.

As can be seen from Table 3, when the ratio of the aperture area of the fourth sub-pixel 14 to the aperture area of the red sub-pixel 11 is greater than 0.4, and the full width at half maximum of the emission peak in the emission spectrum of the fourth sub-pixel 14 is less than 60 nm, the percentage reduction in white-light power consumption is greater than or equal to 10%. Furthermore, when the emission peak of the fourth sub-pixel 14 is located in the deep-red wavelength band, the smaller the full width at half maximum of the emission peak, the further the color gamut coverage is improved. Furthermore, when the full width at half maximum of the emission peak of the fourth sub-pixel 14 is less than 35 nm, and the wavelength difference between the emission peak of the fourth sub-pixel 14 and the emission peak of the red sub-pixel 11 is greater than 15 nm, the color gamut coverage is further improved.

In some embodiments, when the emission peak of the fourth sub-pixel 14 is located in the blue light wavelength band, the light-emitting layer 53 of the corresponding light-emitting device 5 includes a first host material and a phosphorescent light-emitting material, and the light-emitting layer 53 of the light-emitting device 5 corresponding to the blue sub-pixel 13 includes a second host material and a fluorescent light-emitting material. By respectively adopting phosphorescent and fluorescent emission structures in different blue sub-pixels, refined functional differentiation and coordinated control of blue-light emission can be achieved while taking into account luminous efficiency, lifetime, and chromaticity stability, thereby further optimizing the overall performance of the display panel 100.

In a specific embodiment, the first host material and/or the second host material includes an N-type compound and a P-type compound.

In a specific embodiment, the N-type compound includes 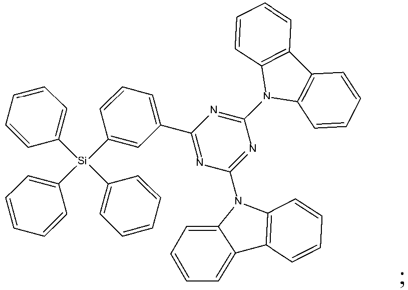 the P-type compound includes 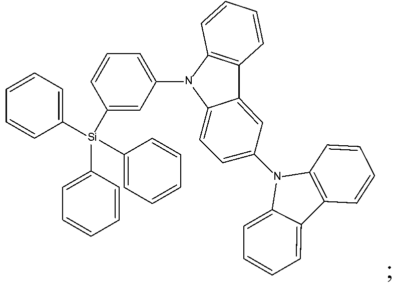 the phosphorescent light-emitting material includes 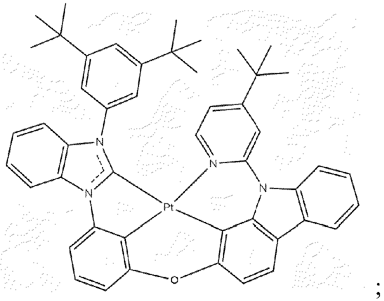 and the fluorescent light-emitting material includes

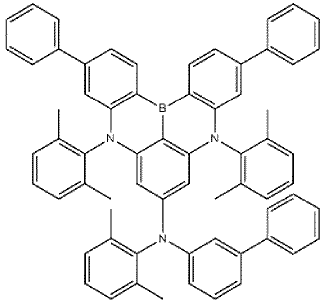

Referring to FIG. 4, in some embodiments, the display panel 100 further includes an encapsulation structure 6 that at least covers the light-emitting device 5 and is configured to protect the substrate 3 and the light-emitting device 5.

In the description of the present application, the terms "first" and "second" are used merely for descriptive purposes and should not be construed as indicating or implying relative importance, nor as implicitly specifying the quantity of the technical features indicated. Thus, features defined as "first" or "second" may explicitly or implicitly include one or more features. In the description of the present application, the term "a plurality of" means two or more than two, unless otherwise specified.

In the above-mentioned embodiments, the description of each embodiment has its own emphasis, and the parts not described in detail in a certain embodiment may be referred to the related description of other embodiments.

The embodiments, implementations, and related technical features of the present application can be combined and replaced with each other without conflict.

The above are merely preferred embodiments of the present application, and do not limit the present application in any form.

## Claims

1. A display panel (100), **characterized by** comprising a plurality of pixel units (1), wherein each of the plurality of pixel units (1) comprises a red sub-pixel (11), a green sub-pixel (12), a blue sub-pixel (13), and a fourth sub-pixel (14);
wherein a ratio of an aperture area of the fourth sub-pixel (14) to an aperture area of the red sub-pixel (11) is greater than 0.4, and a full width at half maximum of an emission peak in an emission spectrum of the fourth sub-pixel (14) is less than 60 nm.

2. The display panel (100) according to claim 1, **characterized in that** a ratio of the aperture area of the red sub-pixel (11), an aperture area of the green sub-pixel (12), and an aperture area of the blue sub-pixel (13) is 1:(0.7-1.3):(0.8-2.8); and/or
the ratio of the aperture area of the fourth sub-pixel (14) to the aperture area of the red sub-pixel (11) is less than or equal to 2.5; and/or
the full width at half maximum of the emission peak in the emission spectrum of the fourth sub-pixel (14) is greater than or equal to 18 nm and less than or equal to 35 nm.

3. The display panel (100) according to claim 1, **characterized in that** a ratio of the aperture area of the red sub-pixel (11), an aperture area of the green sub-pixel (12), and an aperture area of the blue sub-pixel (13) is 1:(0.8-1.0):(1.5-1.8).

4. The display panel (100) according to claim 1, **characterized in that** the ratio of the aperture area of the fourth sub-pixel (14) to the aperture area of the red sub-pixel (11) is greater than or equal to 0.7 and less than or equal to 1.8.

5. The display panel (100) according to claim 1, **characterized in that** a ratio of the aperture area of the red sub-pixel (11), an aperture area of the green sub-pixel (12), and an aperture area of the blue sub-pixel (13) is 1:(0.8-1.0):(1.5-1.8), and the ratio of the aperture area of the fourth sub-pixel (14) to the aperture area of the red sub-pixel (11) is greater than or equal to 0.7 and less than or equal to 1.8.

6. The display panel (100) according to claim 1, **characterized in that** a minimum value among an absolute value of a difference between a peak wavelength of the emission spectrum of the fourth sub-pixel (14) and a peak wavelength of an emission spectrum of the red sub-pixel (11), an absolute value of a difference between the peak wavelength of the emission spectrum of the fourth sub-pixel (14) and a peak wavelength of an emission spectrum of the green sub-pixel (12), and an absolute value of a difference between the peak wavelength of the emission spectrum of the fourth sub-pixel (14) and a peak wavelength of an emission spectrum of the blue sub-pixel (13) is greater than or equal to 5 nm.

7. The display panel (100) according to claim 1, **characterized in that** a peak wavelength of the emission spectrum of the fourth sub-pixel (14) is located in a red light wavelength band and is greater than a peak wavelength of an emission spectrum of the red sub-pixel (11); ora peak wavelength of the emission spectrum of the fourth sub-pixel (14) is located in a cyan light wavelength band.

8. The display panel (100) according to claim 1, **characterized in that** a peak wavelength of the emission spectrum of the fourth sub-pixel (14) is located in a cyan light wavelength band, and a difference between the peak wavelength of the emission spectrum of the fourth sub-pixel (14) and a peak wavelength of an emission spectrum of the blue sub-pixel (13) is less than a difference between a peak wavelength of an emission spectrum of the green sub-pixel (12) and the peak wavelength of the emission spectrum of the fourth sub-pixel (14).

9. The display panel (100) according to claim 1, **characterized in that** a peak wavelength of the emission spectrum of the fourth sub-pixel (14) is located in a cyan light wavelength band, and the emission spectrum of the fourth sub-pixel (14) satisfies at least one of conditions (a)-(d):
(a) a difference between the peak wavelength of the emission spectrum of the fourth sub-pixel (14) and a peak wavelength of an emission spectrum of the blue sub-pixel (13) is less than or equal to 15 nm;
(b) a difference between a peak wavelength of an emission spectrum of the green sub-pixel (12) and the peak wavelength of the emission spectrum of the fourth sub-pixel (14) is greater than or equal to 50 nm and less than or equal to 60 nm;
(c) the full width at half maximum of the emission peak in the emission spectrum of the fourth sub-pixel (14) is less than or equal to 28 nm;
(d) the peak wavelength of the emission spectrum of the fourth sub-pixel (14) is greater than or equal to 465 nm and less than or equal to 475 nm.

10. The display panel (100) according to claim 1, **characterized in that** a peak wavelength of the emission spectrum of the fourth sub-pixel (14) is located in a red light wavelength band, and emission spectra of sub-pixels in each of the plurality of pixel units (1) satisfy at least one of conditions (e)-(h):
(e) a difference between the peak wavelength of the emission spectrum of the fourth sub-pixel (14) and a peak wavelength of an emission spectrum of the red sub-pixel (11) is greater than or equal to 15 nm and less than or equal to 30 nm;
(f) a peak wavelength of an emission spectrum of the red sub-pixel (11) is greater than or equal to 620 nm and less than or equal to 630 nm;
(g) the peak wavelength of the emission spectrum of the fourth sub-pixel (14) is greater than or equal to 640 nm and less than or equal to 655 nm;
(h) the full width at half maximum of the emission peak in the emission spectrum of the fourth sub-pixel (14) is less than or equal to 35 nm.

11. The display panel (100) according to claim 6, **characterized in that** the aperture area of the fourth sub-pixel (14) is less than or equal to the aperture area of the red sub-pixel (11) and/or the aperture area of the fourth sub-pixel (14) is less than or equal to an aperture area of the green sub-pixel (12).

12. The display panel (100) according to claim 6, **characterized in that** the ratio of the aperture area of the fourth sub-pixel (14) to the aperture area of the red sub-pixel (11) is less than or equal to 0.8.

13. The display panel (100) according to claim 1, **characterized in that** a peak wavelength of the emission spectrum of the fourth sub-pixel (14) is in a blue light wavelength band, and a current efficiency of the fourth sub-pixel (14) is greater than a current efficiency of the blue sub-pixel (13).

14. The display panel (100) according to claim 13, **characterized in that** an absolute value of a difference between the peak wavelength of the emission spectrum of the fourth sub-pixel (14) and a peak wavelength of an emission spectrum of the blue sub-pixel (13) is less than or equal to 2 nm; and/or
a ratio of the current efficiency of the fourth sub-pixel (14) to the current efficiency of the blue sub-pixel (13) is greater than or equal to 1.1; and/or
the full width at half maximum of the emission peak in the emission spectrum of the fourth sub-pixel (14) is less than or equal to 21 nm; and/or
the aperture area of the fourth sub-pixel (14) is greater than the aperture area of the red sub-pixel (11); and/or
the aperture area of the fourth sub-pixel (14) is greater than an aperture area of the green sub-pixel (12).

15. The display panel (100) according to claim 13, **characterized in that** the aperture area of the fourth sub-pixel (14) is greater than an aperture area of the blue sub-pixel (13); and/or
a ratio of the current efficiency of the fourth sub-pixel (14) to the current efficiency of the blue sub-pixel (13) is greater than or equal to 2.2.
